# EUROPEAN PATENT APPLICATION

(11) **EP 3 136 600 A1**
(43) Date of publication of application: **01.03.2017**
(21) Application number: 16161428.4
(22) Date of filing: 21.03.2016
(51) Int. Cl.: H03K 17/12

(54) **A POWER TRANSISTOR DEVICE AND PROTECTION METHOD THEREFOR**

(30) Priority: 28.08.2015 IT UB20153275
(71) Applicant: STMicroelectronics S.r.l., 20864 Agrate Brianza (MB) (IT)
(72) Inventor: RUGGERI, Rosario, I-98148 Messina (IT); GRAZIANO, Vito, I-90133 Palermo (IT)
(74) Representative: Bosotti, Luciano

(57) **Abstract**

A power transistor device (10, 12) such as e.g. a Power MOS device includes a control line (16) for controlling a device current (Iout) flowing through the device. The device (10, 12) includes a plurality of cells (6) contributing respective fractions of the device current (Iout) with a plurality of control terminals (G) each adapted to control current flow through one of the cells (6). The device includes respective decoupling resistors (18) between the control line (16) and the control terminals (G). Upon failure of one of the cells (6), the other non-failed cells (6) can be rendered non conductive by a switch-off control signal applied via the control line (16).

## Description

### Technical field

The description relates to power transistor devices.

One or more embodiments may apply e.g. to preventing the risk of fire in power transistor devices such as Power MOS in the event of failure in high dissipative mode.

### Technological background

Failure in high dissipative mode of a power transistor device such as a Power MOS may lead the device to dissipate heat in excess of the amount contemplated for the most critical environmental and application conditions.

A power transistor device can fail in a short-circuit resistive mode (with a voltage drop becoming higher than expected for normal operative conditions). In certain cases this failure mode may evolve to an open circuit (e.g. because the bonding wires blow so that current flow is interrupted).

Failure as an open circuit, with current flow interrupted, is unlikely to give rise to hazard conditions for the device. Conversely, when a power device such as a Power MOS fails in the resistive mode, the junction temperature can easily reach temperatures beyond the maximum allowed operating temperature (e.g. 200°C) .

Such overheating may lead to various undesirable consequences such as e.g.:
- the package molding compound may start emitting smoke (e.g. at 350°C);
- the bonding wires may become red-hot, possibly reaching a temperature capable of producing ignition of the package molding compound; a risk of fire may ensue which can be extinguished (only) once the current flow is interrupted, so that the wires cool down;

- the solder paste may become liquid, which may lead to a displacement of the device with respect to its mounting substrate (e.g. a Printed Circuit Board or PCB),
- degradation of the substrate (e.g. PCB) may result in insulation between adjacent layers being jeopardized.

### Object and summary

An object of one or more embodiments is to provide a power transistor device with improved behavior in case of failure e.g. in high dissipative mode.

According to one or more embodiments, that object is achieved by means of a power transistor device having the features set forth in the claims that follow.

One or more embodiments may also relate to a corresponding method of protection.

The claims are an integral part of the disclosure of one or more embodiments as provided herein.

One or more embodiments may be based on the recognition that in case of failure of a power transistor devices such as Power MOS device, current may cease to flow through the device only if all the wires are open circuits.

In most applications, such as low-ohmic power devices, the current values which may lead to the wires becoming open-circuited may be very high and unlikely to be reached merely as a result of failure. The bonding wires, either gauge or number of wires in parallel, are chosen based on the device protection characteristic (e.g. current limitation value). In other words they allow the current protection value without opening. This may make them fairly over-dimensioned compared to the typical load current for a given device. In case of PowerMOS failure in high dissipative mode, the load current flows through the damaged portion of the PowerMOS (usually quite small compared to the whole active area) and through the bonding wires, whose melting current is well above this value.

One or more embodiments may permit to stop current flow at lower values, e.g. as a function of the number of output wires and the dimensions of the area failed in the device.

### Brief description of the figures

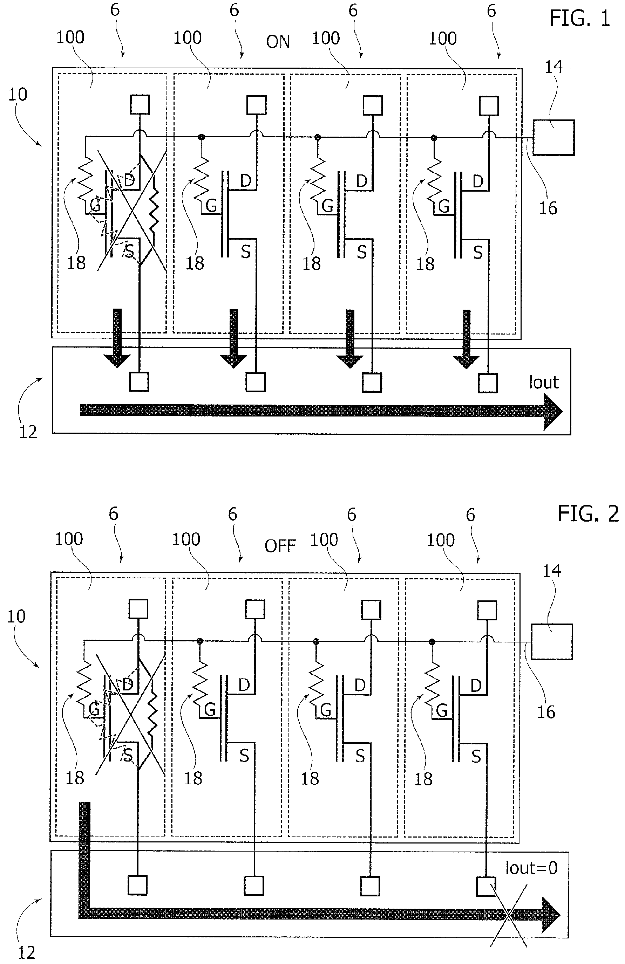

One or more embodiments will now be described, by way of example only, with reference to the annexed figures, including two figures, namely Figure 1 and Figure 2.

The figures are schematic representations of a power transistor device according to one or more embodiments in different conditions related to a possible failure.

### Detailed description

In the ensuing description one or more specific details are illustrated, aimed at providing an in-depth understanding of examples of embodiments. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The references used herein are provided merely for convenience and hence do not define the extent of protection or the scope of the embodiments.

Failure of a power transistor device such as, e.g. a Power MOS as an open circuit may result in the device being incapable of turning on and of supplying the load.

Failure of a power transistor device such as, e.g. a Power MOS in a resistive mode may involve a short-circuit between drain and source and/or a short circuit between drain and gate, the former event being generally more likely than the latter.

Failure as a short-circuit makes the device incapable of turning off. In this condition the MOSFET resistance becomes higher than the typical Rds,on because of a limited damaged area. Then there is a likelihood that a high temperature may be reached with a risk of ignition of the molding compound and, more generally, of fire in the device.

Also it was observed that events which may lead to failure such as a drain-source structure failure in a Power MOS may include e.g.:
- energy discharge exceeding the device energy capability, with the device failing because of secondary breakdown (hot spot): e.g. the MOSFET residual resistance becomes higher than the typical Rds,on because of a limited damaged area;
- a short circuit event (which may derive e.g. from fast thermal fatigue leading to metal spiking with a following short-circuit of the Power MOS structure): failure may occur in a limited region as a consequence of the thermal fatigue being fast;
- ElectroStatic Discharge (ESD) events, which may lead to failure e.g. in the MOSFET body or along its perimeter and/or failure in the controller stage connected in parallel to the power device,
- fast and energetic transients as those contemplated in the ISO7637/2 standard. For instance a MOSFET may fail in case of a negative transient on the device output while the device is supplied by the battery: in that case failure derives from secondary breakdown (hot spot) with the failed area being usually limited.

It was observed that the various failure mechanisms considered in the foregoing mostly cause the device to fail over a limited portion of its area, with possible propagation of the failure depending on factors such as e.g. the resistance from battery to load ground (that is, not including the device), the current capability of the wires (e.g. copper) and the load characteristics.

Also, it was observed that these failure modes are likely to lead to uncontrolled operating conditions involving a high power dissipation level with the potential risk of fire in an application environment.

It was further observed that failure may start as a result of stresses that have exceeded the safe operating area (SOA) of the device over a limited portion of the device. This causes the whole load current to flow through that portion to be then transferred outside the device by bonding wires.

The bonding wires may be chosen to guarantee device operation even in extreme operating cases (e.g. overload), that is chosen in such a way as to allow the maximum current the device can handle (the current limitation) without failing (burn-out) even in the worst case environmental conditions. In that way, the bonding wires may turn out to be largely over-dimensioned with respect to a typical expected load characteristic.

One or more embodiments may involve collecting the load current that flows through the failed portion of the power device over a (limited) number of bonding wires and not all of them as per the current solution. While this may not lead to a reduction of the junction temperature in the portion of the device subject to failure, this solution may reduce its current capability while the other wires may be brought to a condition where no current flows since the remaining part of the device is switched off.

As schematically represented in the figures, this result may be reached in one or more embodiments by sub-dividing (that is, partitioning) the electrically conductive surface (e.g. the source) of the device in a plurality of portions connected externally by a limited number of bonding wires (e.g. even one) with the capability of accessing each single element resulting from such partitioning by means of a dedicated control terminal (e.g. a gate pad) that is decoupled from the others and from the gate driver by a resistor such as a polysilicon resistor.

In the schematic representation of the Figures reference 10 denotes as a whole a power transistor device such as e.g. a Power MOS mounted onto a package lead 12.

As indicated, when a power transistor device such as a Power MOS fails, the gate may be shorted either to the source or to the drain or to both of them. Depending on the residual resistance R_{gate-drain} and R_{gate-source}, the gate voltage V_{gate} may reach any value between the power supply (e.g. battery) and ground.

The representations of Figures 1 and 2 are exemplary of power transistor devices such as Power MOS devices including a plurality of elementary cells 6 which may include e.g. a plurality of e.g. source metal plates 100 while a single metal layer e.g. in the package lead 12 may contact all the gates of the elementary MOSFET cells 6.

Possible embodiments of a such "cellular" MOS power device can be found e.g. in US 5 631 476 A or US 5 851 855 A. Such a cellular power device (which may be, for instance, a FET such as e.g. a Power MOSFET or a bipolar transistor such as e.g. an Insulated Gate Bipolar Transistor - IGBT) may include a plurality of elementary functional cells 6 contributing respective fractions to the overall output current Iout through the device.

In embodiments as disclosed e.g. in the documents cited in the foregoing, the device may include e.g. a N+ semiconductor substrate over which a N-semiconductor layer is formed, e.g. by epitaxial growth. A plurality of elementary MOSFET cells 6 may thus be formed in the N- layer with each cell 6 including, e.g. a P-type body region with a polygonal layout (e.g. a square layout) including a P+ deep body region and a lateral P- channel region with an annular N+ source region formed in each body region. The surface of the N- layer may be selectively covered by a conductive insulated gate layer.

The insulated gate layer may extend over the channel regions while being absent over the middle portion of each elementary cell 6, thus forming a sort of mesh over the N-layer. The insulated gate layer may be covered by an insulating metal layer, in which contact windows may be opened over each elementary cell.

The possibility also exists of providing a plurality of gate metal pads which may be connected by respective wires to separate package pins.

Further details of manufacturing such devices may be gathered from the two documents cited in the foregoing, thus making it unnecessary to provide a more detailed description herein: the same numbering of those documents has been retained in the previous recap in order to facilitate a prompt reference thereto.

In the schematic representations of Figures 1 and 2, the block designated 14 is exemplary of a gate driver module (of a known type) which is coupled with the control terminals (e.g. gate pads G) of the various cells 6 with each said pad adapted to control a current flow through a respective one of the cells 6.

In one or more embodiments the gate driver 14 may be coupled to the control pads G via a common line 16 with a respective decoupling resistor 18 arranged between the control line 16 and each one of the control pads or gates G.

In one or more embodiments, the decoupling resistors 18 may include polysilicon decoupling resistors.

In one or more embodiments, the decoupling resistors 18 (which may be easily included in slow switching devices such as High Side Drivers or HSDs) may be dimensioned as a function of the dynamic resistance in the on and off mode of a gate driver 14 so that:
- any of the cells 6 affected by a failure may be isolated from the other cells upon the occurrence of the failure, and
- the other, non-failed cells will not be affected and will retain the capability of being driven by the gate driver 14.

Consequently, if one of the cells (e.g. the leftmost cell in Figure 2) fails in short-circuit condition, such a cell will no longer be able to be turned off, which may cause the load current Iout to flow (at least for the most part) through it. Since the associated wire may not be dimensioned to handle the whole load current, the wire will expectedly open by isolating the area subject to failure.

In one or more embodiments as exemplified herein, due to the presence of the decoupling resistors 18, the condition Vgate ≤ Vbatt occurring at the cells subject to failure will not prevent the other cells 6 from being capable of being driven by the gate driver 14, since the cell subject to failure will be isolated and insulated with respect to the other cells.

Consequently, upon detecting a failure occurring in one of the cells 6 (which may be detected e.g. by an increased Rds,on) the gate driver 14 may still drive the other cells (not subject to failure) from the "on" condition represented in Figure 1 to the "off" condition represented in Figure 2 so that the current Iout will be interrupted (that is Iout = 0). Current flow through the power device will be interrupted thus avoiding any hazard condition for the device.

Without prejudice to the underlying principles, the details and embodiments may vary, even significantly, with respect to what has been described in the foregoing by way of example only without departing from the extent of protection.

The extent of protection is defined by the annexed claims.

## Claims

1. A power transistor device (10, 12) including a control line (16) for controlling a device current (Iout) flowing through the device, the device (10, 12) including a plurality of cells (6) contributing respective fractions of said device current (Iout) with a plurality of control terminals (G) each adapted to control current flow through one of the cells in said plurality of cells (6), wherein the device includes respective decoupling resistors (18) between said control line (16) and said control terminals (G).

2. The power transistor device of claim 1, wherein said cells (6) in said plurality of cells include MOSFET cells, wherein said control terminals are gate pads (G) of said MOSFET cells.

3. The power transistor device of claim 1 or claim 2, wherein the cells in said plurality of cells (6) are connected in parallel so that said device current (Iout) is the sum of the currents flowing through the cells in said plurality of cells (6).

4. The power transistor device of any of the previous claims, wherein said control line (16) includes a common control line for said plurality of cells (6) with said respective decoupling resistors (18) set between said common control line (16) and said control terminals (G) of said cells of said plurality of cells (6).

5. The power transistor device of any of the previous claims, wherein said decoupling resistors include polysilicon resistors (18).

6. A method of protecting power transistor devices (10, 12) including a control line (16) for controlling a device current (Iout) flowing through the device, the device (10, 12) including a plurality of cells (6) contributing respective fractions of said device current (Iout), the method including:
- providing a plurality of control terminals (G) each adapted to control current flow through one of the cells in said plurality of cells (6),
- providing respective decoupling resistors (18) between said control line (16) and said control terminals (G), and
- upon failure of one of said cells in said plurality of cells (6), switching off the other non-failed cells in said plurality of cells (6) to render said non-failed cells non conductive by a switch-off control signal applied via said control line (16).
